# EUROPEAN PATENT APPLICATION

(11) **EP 4 808 337 A1**
(43) Date of publication of application: **16.09.2026**
(21) Application number: 26162254.2
(22) Date of filing: 04.03.2026
(51) Int. Cl.: H10P 72/76, H10P 72/00

(54) **METHOD OF PROCESSING SUBSTRATE AND SUBSTRATE PROCESSING APPARATUS**

(30) Priority: 11.03.2025 JP 2025037991
(71) Applicant: SCREEN Holdings Co., Ltd., Kyoto-shi, Kyoto 602-8585 (JP)
(72) Inventor: NISHIMURA, Yuta, Kyoto, 602-8585 (JP)
(74) Representative: Kilian Kilian & Partner mbB

(57) **Abstract**

A method of processing a substrate W includes: holding the substrate W; and dispensing a processing liquid from a plurality of outlets of an elongated nozzle toward a main surface of the substrate W while the substrate W is rotated and the elongated nozzle is moved along a longitudinal direction, the elongated nozzle extending along the longitudinal direction, the plurality of outlets being aligned along the longitudinal direction.

## Description

### BACKGROUND

### Technical Field

The present disclosure relates to a method of processing a substrate and a substrate processing apparatus.

### Description of the Background Art

Substrate processing apparatuses each supplying processing liquids to a substrate to process the substrate have been conventionally proposed (for example, Japanese Patent Application Laid-Open No. 2024-91251). In Japanese Patent Application Laid-Open No. 2024-91251, a substrate processing apparatus includes a substrate holder and a first nozzle. The substrate holder rotates a substrate about a vertical rotation axis that passes through the center of the substrate, while holding the substrate in a horizontal attitude. The first nozzle has a long shape extending in a direction along the main surface of the substrate. The first nozzle includes a plurality of outlets arranged in the longitudinal direction. The first nozzle can be referred to as a shower nozzle.

The first nozzle dispenses a processing liquid from the plurality of outlets toward the main surface of the rotating substrate with the longitudinal direction being along a radial direction of the substrate. Consequently, a process corresponding to the processing fluid can be performed on the substrate.

In Japanese Patent Application Laid-Open No. 2024-91251, the substrate processing apparatus dispenses the processing liquid from the first nozzle while oscillating the first nozzle by rotating the first nozzle about a central axis line closer to a base end of the first nozzle in forward and reverse directions in a predetermined angle range. The central axis line is an axis line extending along a vertical direction outside the substrate holder. This rotation allows the first nozzle to reciprocate in a circumferential direction of the central axis line.

### SUMMARY

In Japanese Patent Application Laid-Open No. 2024-91251, when the first nozzle is rotated about the central axis line, the outlets of the first nozzle move along the circumferential direction of the central axis line. However, each of the outlets moves along the circumferential direction within a movement range that is narrower as the outlet is closer to the central axis line. Thus, the movement range of the outlet closer to the outer periphery of the substrate is narrow. Consequently, there is a danger that a process on an outer periphery portion of the main surface of the substrate becomes non-uniform.

The present disclosure herein has an object of providing a technology that can more uniformly process the main surface of the substrate.

According to one aspect, a method of processing a substrate includes: holding the substrate; and dispensing a processing liquid from a plurality of outlets of an elongated nozzle toward a main surface of the substrate while the substrate is rotated and the elongated nozzle is moved along a longitudinal direction, the elongated nozzle extending along the longitudinal direction, the plurality of outlets being aligned along the longitudinal direction.

According to one aspect, a substrate processing apparatus includes: a substrate holder that rotates a substrate while holding the substrate; a dispenser including an elongated nozzle including a plurality of outlets, the dispenser dispensing a processing liquid from the plurality of outlets toward a main surface of the substrate, the plurality of outlets being aligned along a longitudinal direction of the elongated nozzle; and a first movement driver that moves the elongated nozzle along the longitudinal direction.

These and other objects, features, aspects, and advantages of the present disclosure will become more apparent from the following detailed description of the present disclosure when taken in conjunction with the accompanying drawings.

### BRIEF DESCRIPTION OF THE DRAWINGS

FIG. 1 is a plan view schematically illustrating an example structure of a substrate processing apparatus;
FIGS. 2A and 2B are plan views each schematically illustrating an example structure of a substrate;
FIG. 3 is a cross-sectional view schematically illustrating an example of a part of the structure of the substrate;
FIG. 4 is a block diagram schematically illustrating an example configuration of a controller;
FIG. 5 is a diagram schematically illustrating an example structure of a processing part;
FIG. 6 is a flowchart illustrating example processes on a substrate;
FIG. 7 is a vertical cross-sectional view schematically illustrating an example state of the processing part in a processing liquid supply step;
FIG. 8 is a plan view schematically illustrating an example state of the processing part in the processing liquid supply step;
FIG. 9 is a plan view schematically illustrating another example state of the processing part in the processing liquid supply step;
FIG. 10 is a plan view schematically illustrating an example structure of the substrate with a support substrate on which dies are disposed in the second arrangement mode;
FIG. 11 is a flowchart illustrating an example method of determining a position of an elongated nozzle in a movement direction;
FIG. 12 is a diagram schematically illustrating an example structure of the processing part including a camera; and
FIG. 13 is a flowchart illustrating example operations of the processing part including the camera.

### DESCRIPTION OF THE EMBODIMENTS

Embodiments will be described in detail below with reference to drawings. It should be noted that dimensions and the number of parts are shown in exaggeration or in simplified form as appropriate for the sake of easier understanding. The same reference signs are assigned to parts having similar structures and functions, and overlapping description will be omitted in the following description.

In the following description, the same reference signs are assigned to the same constituent elements, and their names and functions are the same. Therefore, detailed description of such constituent elements may be omitted to avoid redundant description.

Even when the ordinal numbers such as "first" and "second" are used in the following description, these terms are used for convenience to facilitate the understanding of the details of Embodiments. The order that can be indicated by these ordinal numbers does not restrict the details of Embodiments.

Unless otherwise noted, the expressions indicating relative or absolute positional relationships (e.g., "in one direction", "along one direction", "parallel", "orthogonal", "central", "concentric", and "coaxial") include those exactly indicating the positional relationships and those where an angle or a distance is relatively changed within tolerance or to the extent that similar functions can be obtained. Unless otherwise noted, the expressions indicating equality (e.g., "same", "equal", and "homogeneous") include those indicating quantitatively exact equality and those in the presence of a difference within tolerance or to the extent that similar functions can be obtained. Unless otherwise noted, the expressions indicating shapes (e.g., "rectangular" or "cylindrical") include those indicating geometrically exact shapes and those indicating, for example, roughness or a chamfer to the extent that similar advantages can be obtained. An expression "comprising", "including", "containing", or "having" one constituent element is not an exclusive expression for excluding the presence of the other constituent elements. An expression "at least one of A, B, and C" involves "only A", "only B", "only C", "any two of A, B, and C", and "all of A, B, and C".

### [Embodiment 1]

### [Overall structure of substrate processing apparatus]

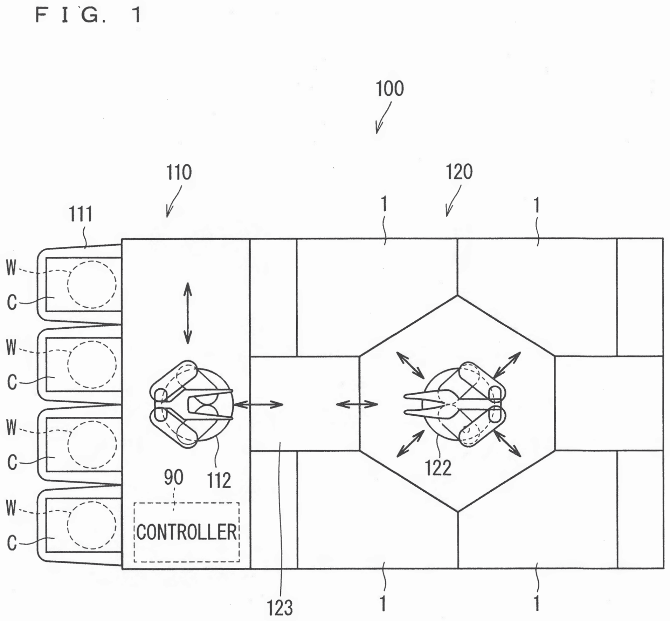

FIG. 1 is a plan view schematically illustrating an example structure of a substrate processing apparatus 100. The substrate processing apparatus 100 is a single-wafer processing apparatus that processes substrates W one by one.

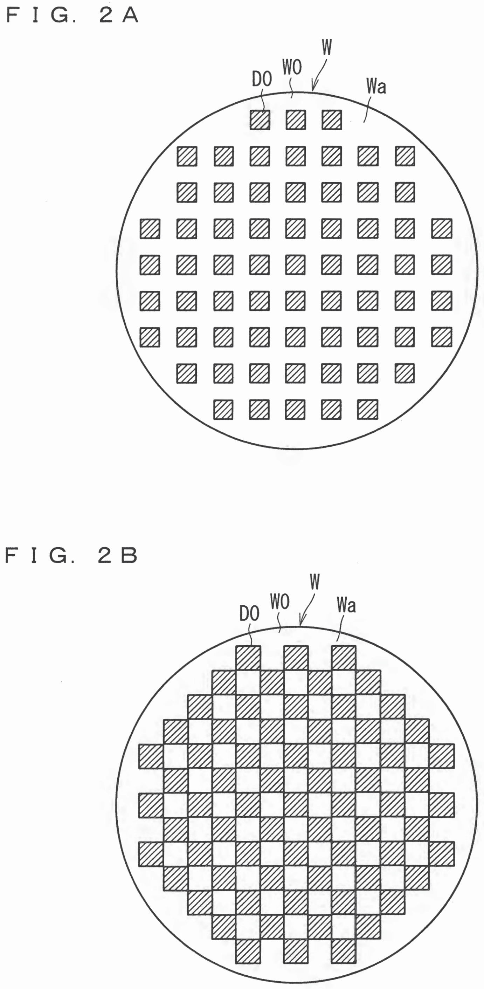

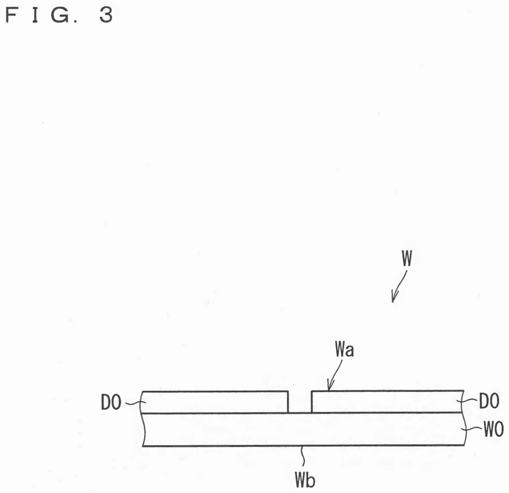

FIGS. 2A and 2B are plan views each schematically illustrating an example structure of the substrate W, and FIG. 3 is a cross-sectional view schematically illustrating an example of a part of the structure of the substrate W. The substrate W is plate-shaped. In other words, the substrate W has main surfaces Wa and Wb facing each other in the thickness direction. As illustrated in FIGS. 2A and 2B and 3, the substrate W may include a plurality of dies D0 on the main surface Wa. The dies D0 are chips each including an electronic circuit. The die D0 can be referred to as a semiconductor chip.

In the examples of FIGS. 2A and 2B and 3, the substrate W includes a support substrate WO and the plurality of dies D0. The support substrate WO is plate-shaped. The support substrate WO is not particularly limited, but is, for example, a semiconductor substrate, a resin substrate, or a glass substrate. In the examples of FIGS. 2A and 2B, the support substrate WO is disk-shaped. The support substrate WO has a diameter of, for example, approximately 300 mm. For example, both of the main surfaces of the support substrate WO are flat, and the dies D0 are disposed on one of the main surfaces of the support substrate WO.

Each of the dies D0 is plate-shaped, and is disposed on the support substrate WO while one of the main surfaces of the die D0 faces the main surface of the support substrate WO. Each of the dies D0 may be bonded to the support substrate WO via, for example, an adhesive. In the examples of FIGS. 2A and 2B, each of the dies D0 is rectangular in a plan view. The dies D0 are two-dimensionally arranged in a plan view. Specifically, each of the dies D0 is, for example, of a rectangle of approximately 10 mm × 10 mm. In the example of FIG. 2A, the dies D0 are arranged in a matrix where a first direction along one of the sides of the dies D0 is a row direction and a second direction crossing the first direction is a column direction. In the example of FIG. 2B, the dies D0 are arranged in a staggered manner. Each of the dies D0 may have a thickness of, for example, 0.1 mm or more, 0.2 mm or more, 0.5 mm or more, or 1 mm or more. The minimum value of distances between the dies D0 (i.e., a gap between the dies D0) may be, for example, 0.1 µm or more, 1 µm or more, 10 µm or more, 100 µm or more, or 1 mm or more. Furthermore, the maximum value of the distances between the dies D0 may be 2mm or less.

The main surface Wa of the substrate W consists of a portion not covered with the dies D0 on one of the main surfaces of the support substrate WO, and a portion of the surfaces of the dies D0 which does not face the support substrate WO. Thus, the dies D0 form irregularities on the main surface Wa of the substrate W. The dies D0 correspond to projections in the irregularities. Since the thickness of each of the dies D0 is larger than a thickness of a pattern included in the die D0, the depth of the irregularities formed on the main surface Wa of the substrate W is relatively great.

In the example of FIG. 1, the substrate processing apparatus 100 includes an indexer block 110, a processing block 120, and a controller 90. The indexer block 110 is an interface part for loading and unloading the substrates W between the processing block 120 and an exterior. The processing block 120 is a part that mainly processes the substrates W received from the indexer block 110. The controller 90 is a part that has centralized control over the substrate processing apparatus 100.

### [Indexer block 110]

In the example of FIG. 1, the indexer block 110 includes a plurality of load ports 111 and an indexer robot 112. Each of the load ports 111 holds a substrate container (hereinafter referred to as a "carrier C") loaded from an exterior. A plurality of the substrates W are housed in the carrier C while being aligned in the vertical direction. The indexer robot 112 is a transport part that transports the substrates W between each of the carriers C and the processing block 120. The indexer robot 112 sequentially takes unprocessed substrates W from the carriers C, and transports the unprocessed substrates W to the processing block 120. Furthermore, the indexer robot 112 sequentially receives, from the processing block 120, the substrates W processed by the processing block 120, and houses the processed substrates W in the carriers C. The carriers C housing the processed substrates W are unloaded from the load ports 111 to an exterior.

### [Processing block 120]

In the example of FIG. 1, the processing block 120 includes one or more processing parts 1 and a center robot 122. In the example of FIG. 1, the processing block 120 includes a plurality of the processing parts 1. The center robot 122 is a transport part that transports the substrates W between the indexer robot 112 and each of the processing parts 1. In the example of FIG. 1, the center robot 122 receives the unprocessed substrates W from the indexer robot 112, for example, through a placement part 123, and transports the substrates W to the processing parts 1. The placement part 123 may be a stage or a shelve on which the substrates W are placed. The processing parts 1 process the substrates W. The center robot 122 takes the processed substrates W from the processing parts 1, and, for example, transports the substrates W to the indexer robot 112 through the placement part 123.

Each of the processing parts 1 is a single-wafer processing device that processes the substrates W one by one. An example specific structure of the processing part 1 will be described later in detail.

### [Controller 90]

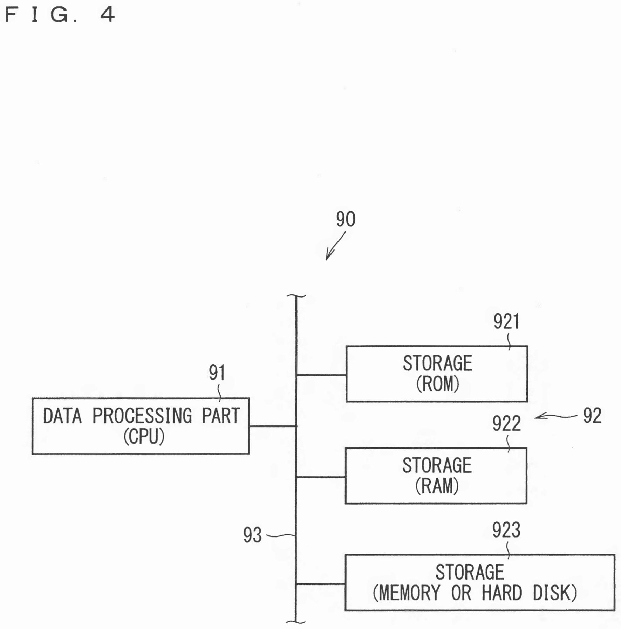

The controller 90 has centralized control over the substrate processing apparatus 100. Specifically, the controller 90 controls the indexer robot 112, the center robot 122, and the processing parts 1. FIG. 4 is a block diagram schematically illustrating an example configuration of the controller 90. The controller 90 is an electronic circuit, and includes, for example, a data processing part 91 and a storage 92. In a specific example of FIG. 4, the data processing part 91 and the storage 92 are mutually connected through a bus 93. The data processing part 91 may be, for example, an arithmetic processing unit such as a central processing unit (CPU). The storage 92 may include a non-transitory storage (e.g., a read-only memory (ROM) or a hard disk) 921 and a transitory storage (e.g., a random-access memory (RAM)) 922. The non-transitory storage 921 may store, for example, a program for defining processes to be executed by the controller 90. The data processing part 91 executes this program, so that the controller 90 can execute the processes defined in the program. Obviously, hardware such as a dedicated logic circuit may execute a part or all the processes to be executed by the controller 90.

In the example of FIG. 4, the controller 90 is also connected to a storage 923. The storage 923 is a non-transitory storage, and includes, for example, at least one of a memory and a hard disk. The storage 923 stores various pieces of data. For example, the storage 923 stores recipe information indicating a procedure of processes on the substrate W.

### [Processing part]

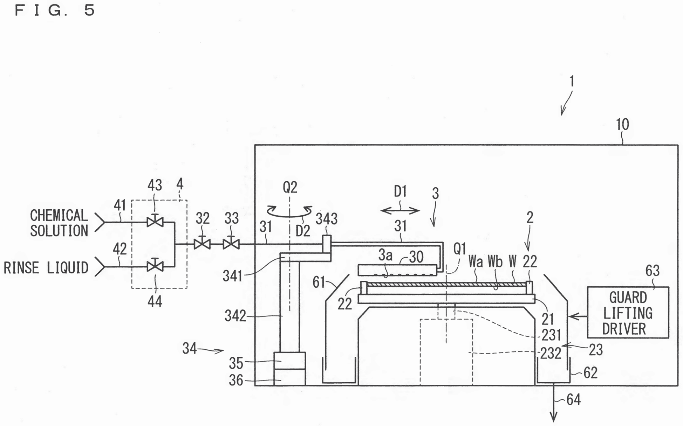

FIG. 5 is a diagram schematically illustrating an example structure of the processing part 1. All the processing parts 1 belonging to the substrate processing apparatus 100 need not have the structure exemplified in FIG. 5. At least one of the processing parts 1 of the substrate processing apparatus 100 should have the structure exemplified in FIG. 5.

The processing part 1 supplies various processing liquids to the main surface Wa of the substrate W to perform, on the substrate W (e.g., the dies D0), processes corresponding to the processing liquids. As illustrated in FIG. 5, the processing part 1 includes a substrate holder 2 and a dispenser 3.

In the example of FIG. 5, the processing part 1 also includes a chamber 10. The chamber 10 is box-shaped. The internal space of the chamber 10 is a processing space in which the substrate W is processed. The chamber 10 includes an openable and closeable loading/unloading entrance (not illustrated). The center robot 122 loads the unprocessed substrate W into the chamber 10 through the loading/unloading entrance, and unloads the processed substrate W from the chamber 10 through the loading/unloading entrance. The substrate W is loaded into the chamber 10 in an attitude such that the main surface Wa faces vertically upward.

The substrate holder 2 is disposed in the chamber 10. The substrate holder 2 rotates the substrate W about a rotation axis line Q1 while holding the substrate W in a horizontal attitude. The horizontal attitude herein is an attitude in which the thickness direction of the substrate W is along the vertical direction. Since the substrate W is loaded with the main surface Wa facing vertically upward, the main surface Wa of the substrate W held by the substrate holder 2 is the upper surface of the substrate W. In other words, the substrate holder 2 holds the substrate W in an attitude such that the main surface Wa faces vertically upward. The rotation axis line Q1 is an axis line that passes through the center of the substrate W and is along the vertical direction. This substrate holder 2 can be referred to as a spin chuck.

In the example of FIG. 5, the substrate holder 2 includes a spin base 21, chuck pins 22, and a rotation driver 23. The spin base 21 is plate-shaped (e.g., disk-shaped), and is disposed in an attitude such that its thickness direction is along the vertical direction.

A plurality of the chuck pins 22 are arranged on the upper surface of the spin base 21. The chuck pins 22 are arranged, for example, at equal intervals along a circumferential direction of the rotation axis line Q1. Each of the chuck pins 22 is displaceable between a holding position and a releasing position to be described next. The holding position is a position at which the chuck pin 22 abuts the outer edge of the substrate W. The chuck pins 22 hold the substrate W by being stopped at the respective holding positions. FIG. 5 illustrates the chuck pins 22 stopped at the holding positions. The releasing position is a position at which each of the chuck pins 22 is away from the substrate W. A hold of the substrate W by the chuck pins 22 is released by stopping the chuck pins 22 at the respective releasing positions. The substrate holder 2 includes a pin driver (not illustrated) that displaces the chuck pins 22. The pin driver includes a driving source, for example, a motor or an air cylinder, and is controlled by the controller 90.

The rotation driver 23 includes a shaft 231 and a motor 232. An upper end of the shaft 231 is connected to a lower surface of the spin base 21. The shaft 231 extends along the rotation axis line Q1 from the lower surface of the spin base 21. The motor 232 is controlled by the controller 90, and rotates the shaft 231 about the rotation axis line Q1. Consequently, the spin base 21, the chuck pins 22, and the substrate W rotate in unison about the rotation axis line Q1.

The substrate holder 2 need not always include the chuck pins 22. The substrate holder 2 may hold the substrate W, for example, in a chuck method such as a vacuum chuck method, an electrostatic chuck method, or a Bernoulli chuck method.

The dispenser 3 includes an elongated nozzle 30. The elongated nozzle 30 has a long shape extending along a longitudinal direction D1. In other words, the length of the elongated nozzle 30 in the longitudinal direction D1 is greater than that in a short direction orthogonal to the longitudinal direction D1. The longitudinal direction D1 is a direction along the main surface Wa of the substrate W (e.g., a horizontal direction). The elongated nozzle 30 includes a plurality of outlets 3a. The outlets 3a are arranged at regular intervals along the longitudinal direction D1 of the elongated nozzle 30. The outlets 3a may be arranged in one column. The number of the outlets 3a is not particularly limited, but may be, for example, ten or more or 15 or more. Each of the outlets 3a may be, for example, circular in a plan view, and its diameter may be set to, for example, approximately several mm. The elongated nozzle 30 is also referred to as a shower nozzle. The elongated nozzle 30 dispenses a processing liquid from the outlets 3a toward the main surface Wa of the substrate W held by the substrate holder 2. The processing liquid is dispensed from the outlets 3a, for example, in the form of continuous streams.

In the example of FIG. 5, the elongated nozzle 30 is disposed vertically above the substrate W held by the substrate holder 2 in the chamber 10. The outlets 3a are formed in the lower surface of the elongated nozzle 30.

In the example of FIG. 5, the elongated nozzle 30 can selectively dispense a chemical solution and a rinse liquid as processing liquids. In the example of FIG. 5, the elongated nozzle 30 is connected to a downstream end of a liquid supply pipe 31. An upstream end of the liquid supply pipe 31 is connected to a switching part 4. The switching part 4 is also connected to a downstream end of a chemical solution supply pipe 41 and a downstream end of a rinse liquid supply pipe 42. An upstream end of the chemical solution supply pipe 41 is connected to a chemical solution supply source (not illustrated), and an upstream end of the rinse liquid supply pipe 42 is connected to a rinse liquid supply source (not illustrated). The switching part 4 is controlled by the controller 90, and switches a pipe connected in communication with the liquid supply pipe 31 between the chemical solution supply pipe 41 and the rinse liquid supply pipe 42.

The switching part 4 may be, for example, a multiple valve. Specifically, the switching part 4 may include a chemical solution valve 43 and a rinse valve 44. These valves are controlled by the controller 90. Upon opening the chemical solution valve 43, the chemical solution supply pipe 41 is connected in communication with the liquid supply pipe 31. Upon opening a valve 32 to be described later in this state, a chemical solution from the chemical solution supply source is supplied to the elongated nozzle 30 through the chemical solution supply pipe 41, the switching part 4, and the liquid supply pipe 31, and is dispensed from the elongated nozzle 30. Upon opening the rinse valve 44, the rinse liquid supply pipe 42 is connected in communication with the liquid supply pipe 31. Upon opening the valve 32 to be described later in this state, a rinse liquid from the rinse liquid supply source is supplied to the elongated nozzle 30 through the rinse liquid supply pipe 42, the switching part 4, and the liquid supply pipe 31, and is dispensed from the elongated nozzle 30.

The chemical solution is, for example, a mixed liquid of sulfuric acid and aqueous hydrogen peroxide (a sulfuric acid hydrogen peroxide mixture abbreviated as SPM). The chemical solution is not limited to SPM, but may be a liquid containing at least one of sulfuric acid, acetic acid, nitric acid, hydrochloric acid, hydrofluoric acid, phosphoric acid, ammonia water, aqueous hydrogen peroxide, organic acid (e.g., citric acid and oxalic acid), organic alkali (e.g. tetramethylammonium hydroxide (TMAH)), a surface active agent, and a corrosion inhibitor. The rinse liquid may be a liquid containing at least one of pure water (i.e., deionized water), carbon dioxide water, and an organic solvent (e.g., isopropyl alcohol).

A heater (not illustrated) may be disposed in the chemical solution supply pipe 41. The heater heats the chemical solution flowing through the chemical solution supply pipe 41 to raise the temperature of the chemical solution to a temperature appropriate for the processing. For example, when a mixed liquid of sulfuric acid and aqueous hydrogen peroxide is applied as a chemical solution, the temperature of the chemical solution may be regulated, for example, in a range higher than the room temperature and lower than or equal to 80 degrees centigrade. The heater is controlled by the controller 90.

In the example of FIG. 5, the valve 32 and a flow regulating valve 33 are inserted into the liquid supply pipe 31. Opening the valve 32 causes the elongated nozzle 30 to dispense a processing liquid, and closing the valve 32 causes the elongated nozzle 30 to stop dispensing the processing liquid. The flow regulating valve 33 regulates a flow rate of the processing liquid flowing through the liquid supply pipe 31. The flow regulating valve 33 may be a massflow controller. The valve 32 and the flow regulating valve 33 are controlled by the controller 90.

In the example of FIG. 5, the processing part 1 also includes a nozzle movement driver 34. The nozzle movement driver 34 is controlled by the controller 90, and moves the elongated nozzle 30 within the chamber 10.

The nozzle movement driver 34 includes a first movement driver 35. The first movement driver 35 is controlled by the controller 90, and moves the elongated nozzle 30 along the longitudinal direction D1. The first movement driver 35 is a direct-acting driver that linearly moves the elongated nozzle 30. The first movement driver 35 includes a driving source such as a motor, and a power transmitter that transmits a driving force of the driving source to the elongated nozzle 30. The power transmitter includes, for example, a direct-acting mechanism such as a ball screw mechanism.

In the example of FIG. 5, the first movement driver 35 is connected to a base end of a support column 342. The support column 342 has a columnar shape extending along the vertical direction. The support column 342 is disposed outward of the substrate holder 2 (further a guard 61 to be described later) in a radial direction in a plan view. A base end of an arm 341 is connected to an upper portion of the support column 342. The arm 341 has a rod shape extending along the horizontal direction. A pipe holder 343 penetrated by the liquid supply pipe 31 is disposed at the tip of the arm 341. The pipe holder 343 holds the liquid supply pipe 31.

In the example of FIG. 5, the first movement driver 35 moves the support column 342 along the longitudinal direction D1. Consequently, the support column 342, the arm 341, and the elongated nozzle 30 move in unison along the longitudinal direction D1. The first movement driver 35 moves the elongated nozzle 30 along the longitudinal direction D1 when the elongated nozzle 30 dispenses a processing liquid, which will be described later in detail.

As exemplified in FIG. 5, the nozzle movement driver 34 may also include a second movement driver 36. The second movement driver 36 moves the elongated nozzle 30 along a movement direction D2 different from a movement direction (i.e., the longitudinal direction D1) of the first movement driver 35. The second movement driver 36 includes, for example, a motor. The second movement driver 36 may rotate the first movement driver 35 about a rotation axis line Q2 extending along the vertical direction. Consequently, the first movement driver 35, the support column 342, the arm 341, and the elongated nozzle 30 move in unison about the rotation axis line Q2. In other words, the elongated nozzle 30 moves along a circumferential direction of the rotation axis line Q2. The movement direction D2 is the circumferential direction of the rotation axis line Q2. Furthermore, the longitudinal direction D1 of the elongated nozzle 30 herein corresponds to a radial direction of the rotation axis line Q2. In other words, the elongated nozzle 30 is attached such that the longitudinal direction D1 is along the radial direction of the rotation axis line Q2. The rotation axis line Q2 passes through, for example, the support column 342.

The second movement driver 36 moves the elongated nozzle 30 between a processing position and a waiting position. The processing position and the waiting position are positions aligned in the circumferential direction (i.e., the movement direction D2) of the rotation axis line Q2. The processing position is a position at which the elongated nozzle 30 dispenses a processing liquid toward the main surface Wa of the substrate W, and is, for example, a position at which the elongated nozzle 30 faces the substrate W held by the substrate holder 2 in the vertical direction. In the example of FIG. 5, the nozzle 30 stopped at the processing position is illustrated. The waiting position is a position at which the elongated nozzle 30 does not dispense a processing liquid toward the substrate W, and is, for example, a position outward of the substrate holder 2 in the radial direction. The waiting position is a position avoiding a transport route of the substrate W between the center robot 122 and the processing part 1. The center robot 122 loads and unloads the substrate W into and out of the processing part 1 while the elongated nozzle 30 is located at the waiting position. Thus, the elongated nozzle 30 does not hinder the center robot 122 from transporting the substrate W.

The second movement driver 36 need not always include the aforementioned structure, and may include, for example, a direct-acting driver such as a ball screw mechanism or a linear motor.

The controller 90 controls the second movement driver 36 such that the elongated nozzle 30 is moved to the processing position. Consequently, the elongated nozzle 30 is located immediately above the main surface Wa of the substrate W held by the substrate holder 2 (see FIG. 5). Then, the controller 90 controls the dispenser 3 such that the elongated nozzle 30 dispenses a processing liquid from the outlets 3a while controlling the substrate holder 2 such that the substrate W is rotated about the rotation axis line Q1 and controlling the first movement driver 35 such that the elongated nozzle 30 is moved along the longitudinal direction D1. The processing liquid from the outlets 3a lands on the main surface Wa of the substrate W at the respective liquid landing positions, flows over the main surface Wa of the substrate W, and flies off or runs down from the outer edge of the substrate W. Here, the processing liquid acts on the main surface Wa of the substrate W, so that the substrate W is subjected to a process corresponding to the type of the processing liquid. The technological implications on the movement of the elongated nozzle 30 in the longitudinal direction D1 during this process will be described later.

In the example of FIG. 5, the processing part 1 also includes the guard 61 and a guard lifting driver 63. The guard 61 is of a tubular shape surrounding the substrate W held by the substrate holder 2. The guard lifting driver 63 is controlled by the controller 90, and lifts and lowers the guard 61 between an upper position and a lower position to be described next. The upper position is a position at which an upper end of the guard 61 is located vertically above the main surface Wa of the substrate W held by the substrate holder 2. FIG. 5 illustrates the guard 61 stopped at the upper position. When the processing liquid flies off outward in the radial direction from the outer edge of the substrate W with the guard 61 being located at the upper position, the guard 61 can receive the flying processing liquid. The lower position is a position at which the upper end of the guard 61 is located vertically below the upper position, and is, for example, a position vertically below the upper surface of the spin base 21. The lower position is a position avoiding the transport route of the substrate W between the center robot 122 and the processing part 1. The guard lifting driver 63 includes, for example, a ball screw mechanism or an air cylinder.

A cup 62 receives the processing liquid running down from the outer edge of the substrate W, and the processing liquid running down along the inner circumferential surface of the guard 61. An upstream end of a collection pipe 64 is connected to a lower portion of the cup 62, so that the processing liquid received by the cup 62 is collected through the collection pipe 64. The cup 62 may be a different entity from the guard 61, or integrally formed with the guard 61.

### [Example processes on substrate]

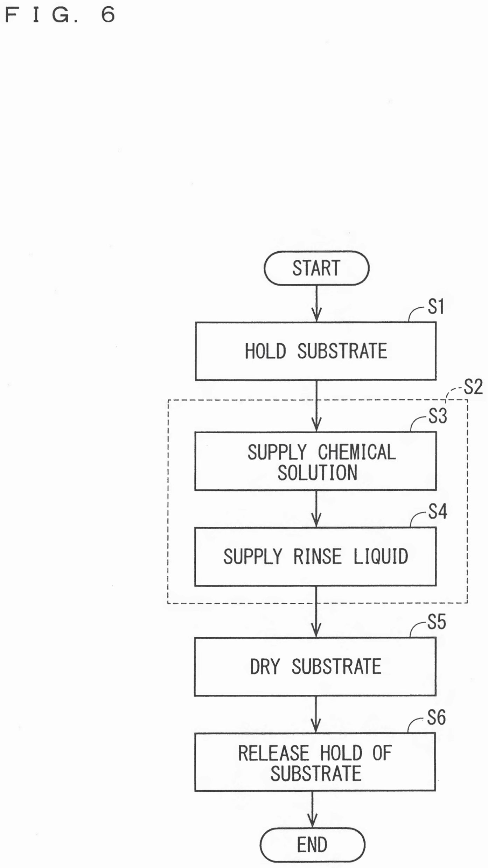

FIG. 6 is a flowchart illustrating example processes on a substrate. The controller 90 controls the substrate processing apparatus 100 according to a predetermined procedure (a recipe), so that the flowchart in FIG. 6 is implemented.

First, the center robot 122 loads the substrate W into the chamber 10 of the processing part 1. Then, the substrate holder 2 receives the substrate W, and holds the substrate W (Step S1: a holding step). As a specific example, the controller 90 controls the substrate holder 2 such that the chuck pins 22 are displaced from the respective releasing positions to the holding positions. Consequently, the chuck pins 22 hold the substrate W. The substrate holder 2 continues to hold the substrate W until the end of the processes on the substrate W.

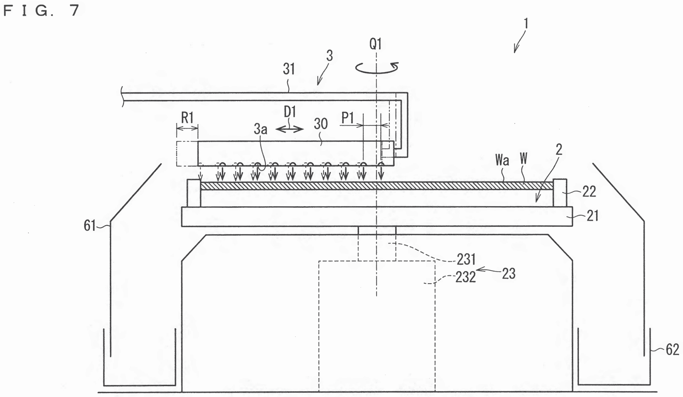

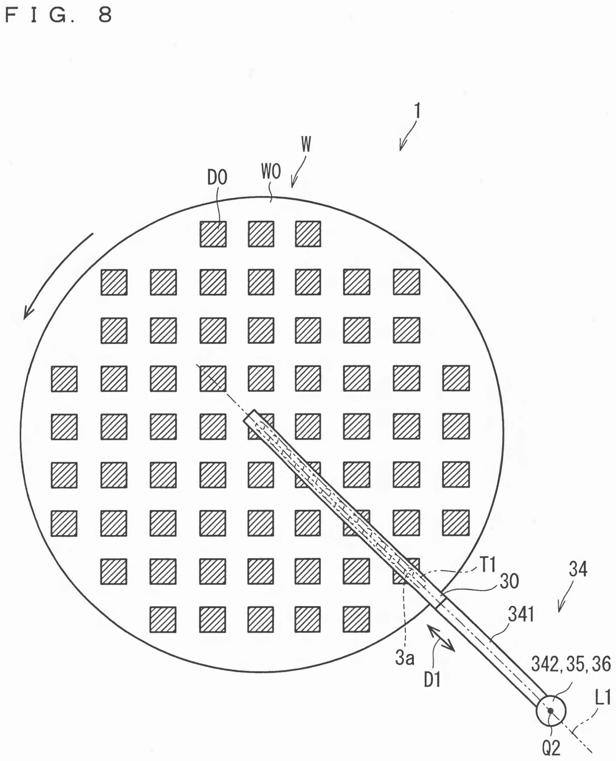

Next, the processing part 1 supplies processing liquids to the main surface Wa of the substrate W (Step S2: a processing liquid supply step). FIG. 7 is a vertical cross-sectional view schematically illustrating an example state of the processing part 1 in Step S2. FIG. 8 is a plan view schematically illustrating an example state of the processing part 1 in Step S2. First, the controller 90 controls the second movement driver 36 such that the elongated nozzle 30 is moved from the waiting position to the processing position. For example, the processing position is a position at which the longitudinal direction D1 of the elongated nozzle 30 is along the radial direction of the substrate W (i.e., the radial direction of the rotation axis line Q1) (see FIG. 8). Put it differently, the processing position is a position at which the longitudinal direction D1 is along a virtual line L1 connecting the rotation axis line Q1 to the rotation axis line Q2 in a plan view. Furthermore, the controller 90 controls the guard lifting driver 63 such that the guard 61 is lifted to the upper position. Furthermore, the controller 90 controls the substrate holder 2 such that the substrate W is rotated about the rotation axis line Q1.

Next, the controller 90 controls the first movement driver 35 such that the elongated nozzle 30 is moved along the longitudinal direction D1, and controls the dispenser 3 such that the elongated nozzle 30 dispenses a processing liquid. Specifically, the controller 90 opens the valve 32. Consequently, the elongated nozzle 30 dispenses a processing liquid from the outlets 3a toward the main surface Wa of the substrate W, while moving along the longitudinal direction D1. In the example of FIG. 7, flows of the processing liquid from the outlets 3a are schematically illustrated by linear one-way arrows. In this Step S2, the controller 90 may control the first movement driver 35 such that the elongated nozzle 30 reciprocates.

The processing liquid from the outlets 3a lands on the main surface Wa of the substrate W at the respective liquid landing positions. Since, for example, the longitudinal direction D1 of the elongated nozzle 30 is along the radial direction of the rotation axis line Q1, the outlets 3a are aligned in the radial direction of the rotation axis line Q1. Thus, the liquid landing positions are also aligned in the radial direction of the rotation axis line Q1. When the elongated nozzle 30 dispenses a processing liquid immediately downward from the outlets 3a, the liquid landing positions match the respective positions of the outlets 3a in a plan view.

The processing liquid that has landed on the main surface Wa of the substrate W at the liquid landing positions flows outward in the radial direction by rotation of the substrate W. Here, the processing liquid acts on the main surface Wa of the substrate W, so that the main surface Wa (the dies D0 as a specific example) of the substrate W is subjected to a process corresponding to the type of the processing liquid.

In Step S2, the substrate holder 2 may rotate the substrate W at a rotation speed enough to cover the surface of the dies D0 on the substrate W with the processing liquid. When the substrate W includes the dies D0, the main surface Wa of the substrate W has deep irregularities. Thus, the rotation speed is relatively low. As a specific example, the substrate holder 2 may rotate the substrate W at a rotation speed lower than or equal to 20 rpm. The rotation speed of the substrate W may be 15 rpm or lower. A target value of the rotation speed of the substrate W may be set constant over Step S2. The controller 90 controls the substrate holder 2 (specifically, the motor 232) based on the target value such that the rotation speed of the substrate W is closer to the target value.

The flow regulating valve 33 may regulate a flow rate of a processing liquid to, for example, 0.1 liter (L)/min or more and 2.0 L/min or less. The flow regulating valve 33 may regulate a flow rate of the processing liquid to, for example, 1.0 L/min or more. As such, when the elongated nozzle 30 dispenses a processing liquid toward the main surface Wa of the substrate W rotating at a low speed, the processing liquid runs down from the outer edge of the substrate W without flying off to the inner circumferential surface of the guard 61.

In Step S2, the processing part 1 may supply processing liquids of a plurality of types to the substrate W. For example, the processing part 1 may supply the substrate W first with a chemical solution as a processing liquid (Step S3: a chemical solution supply step), and then supply the substrate W with a rinse liquid as a processing liquid (Step S4: a rinse liquid supply step). Specifically, the controller 90 first opens the chemical solution valve 43 over a predetermined chemical solution processing time. Upon opening the chemical solution valve 43 and the valve 32, the elongated nozzle 30 dispenses the chemical solution from the outlets 3a toward the main surface Wa of the substrate W. Consequently, the processing part 1 can perform a chemical solution process on the substrate W. For example, a liquid for etching an etching target of the dies D0 is applicable as the chemical solution. As a more specific example, the etching target of the dies D0 is copper, and the chemical solution is diluted SPM.

For example, a timer circuit (not illustrated) of the controller 90 measures an elapsed time. When the elapsed time since start of dispensing the chemical solution exceeds a predetermined chemical solution processing time, the controller 90 closes the chemical solution valve 43.

Then, the controller 90 opens the rinse valve 44 upon closing of this chemical solution valve 43. Consequently, the processing part 1 can perform a rinse process on the substrate W. The rinse liquid is, for example, at least one of pure water and an organic solvent. This rinse process causes the rinse liquid to force the chemical solution out of the main surface Wa of the substrate W outward in the radial direction. Thus, the processing liquid on the main surface Wa of the substrate W is replaced from the chemical solution with the rinse liquid. When the elapsed time since start of dispensing the rinse liquid exceeds a predetermined rinse processing time, the controller 90 closes the valve 32. Then, the controller 90 controls the second movement driver 36 such that the elongated nozzle 30 is moved to the waiting position.

In Step S4, the processing part 1 may sequentially supply pure water and an organic solvent in this order to the main surface Wa of the substrate W as a rinse liquid.

Next, the controller 90 controls the processing part 1 such that the substrate W is dried (Step S5: a drying step). Specifically, the controller 90 controls the substrate holder 2 such that the rotation speed of the substrate W is increased (i.e., spin drying). When the substrate W has sufficiently been dried, the controller 90 controls the substrate holder 2 such that the rotation of the substrate W is stopped.

Next, the controller 90 controls the substrate holder 2 such that a hold of the substrate W is released (Step S6: a hold releasing step). Then, the controller 90 controls the guard lifting driver 63 such that the guard 61 is lowered. Next, the center robot 122 unloads the substrate W from the chamber 10 of the processing part 1.

As described above, the processing part 1 can perform processes on the substrate W. Moreover, the elongated nozzle 30 dispenses a processing liquid from the outlets 3a toward the substrate W, while moving along the longitudinal direction D1 in Step S2 according to Embodiment 1. Thus, the processing liquid dispensed from the outlets 3a lands on the main surface Wa of the substrate W while moving along the longitudinal direction D1. Thus, the processing liquid can more uniformly act on the main surface Wa of the substrate W.

For comparison, a case where the liquid landing positions are constant in Step S2 will be described. In other words, a case where the elongated nozzle 30 at rest dispenses processing liquids in Step S2 will be described. Here, each of the processing liquids continues to land on the main surface Wa of the substrate W at the constant liquid landing positions in the radial direction of the substrate W. Since the substrate W rotates about the rotation axis line Q1, the processing liquid lands on an annular region including the liquid landing positions on the main surface Wa of the substrate W. The annular region is circular with respect to the rotation axis line Q1. Here, a degree of the processing on each of the annular regions on the main surface Wa of the substrate W may be greater than that of the processing on a non-processing liquid landing region except the annular regions. For example, when a processing liquid is a chemical solution such as an etching liquid, there is a danger that an etching amount on the annular region is greater than that in the non-processing liquid landing region. In other words, the uniformity of the processes on the main surface Wa of the substrate W decreases.

When the substrate W includes the dies D0, the main surface Wa of the substrate W has relatively deep irregularities. When the liquid landing positions are constant, the flow of the processing liquid on the main surface Wa of the substrate W tends to become non-uniform. When the rotation speed of the substrate W is low particularly in Step S2, the processing liquid is easily suspended in specific portions of depressions on the main surface Wa of the substrate W. Thus, the flow of processes tends to become non-uniform. Here, the uniformity of the processes on the main surface Wa of the substrate W further decreases.

In contrast, the liquid landing positions move along the longitudinal direction D1 in Step S2 according to Embodiment 1. Thus, the annular region in which the processing liquid lands on the main surface Wa of the substrate W can be enlarged in the radial direction of the rotation axis line Q1. In other words, the liquid landing positions can disperse in the radial direction. Thus, the processing part 1 can process the main surface Wa of the substrate W with higher uniformity. When the liquid landing positions move along the longitudinal direction D1, the flow of the processing liquid on the main surface Wa of the substrate W can be changed. Thus, the non-uniform flow of the processing liquid can be reduced. Thus, the processing part 1 can process the main surface Wa of the substrate W with higher uniformity.

For additional comparison, a case where the second movement driver 36 moves the elongated nozzle 30 in Step S2 will be considered. Here, the first movement driver 35 does not move the elongated nozzle 30 in Step S2. When the second movement driver 36 rotates the elongated nozzle 30 about the rotation axis line Q2, the liquid landing positions move along the circumferential direction of the rotation axis line Q2. However, each of the outlets 3a moves along the circumferential direction within a movement range that is narrower as the outlet is closer to the rotation axis line Q2. Thus, the outlet 3a closer to the rotation axis line Q2 can hardly move in the radial direction of the rotation axis line Q1. In other words, the liquid landing position closer to the rotation axis line Q2 can hardly move in the radial direction of the rotation axis line Q1. Thus, the non-uniformity on the processes can hardly be reduced in an outer periphery portion of the main surface Wa of the substrate W.

In contrast, the elongated nozzle 30 linearly moves along the longitudinal direction D1 in Embodiment 1. Thus, the outlet 3a closer to the rotation axis line Q2 can sufficiently be moved with the radial direction component of the rotation axis line Q1. Thus, the processing part 1 can more uniformly process the outer periphery portion of the main surface Wa of the substrate W.

In the aforementioned example, the second movement driver 36 moves the elongated nozzle 30 between the processing position and the waiting position. In other words, the processing position and the waiting position are aligned in the movement direction D2 crossing the longitudinal direction D1. If the processing position and the waiting position are aligned in the longitudinal direction D1, that is, when the first movement driver 35 moves the elongated nozzle 30 between the processing position and the waiting position, a distance between the processing position and the waiting position is increased by the size of the elongated nozzle 30 in the longitudinal direction D1. This increases the size of the chamber 10, and further increases the size of the substrate processing apparatus 100. In contrast, the size of the substrate processing apparatus 100 can be reduced because the processing position and the waiting position are aligned in the movement direction D2 in the aforementioned example.

### [Movement range]

Next, an example of a movement range R1 of the elongated nozzle 30 in Step S2 will be described. The movement range R1 may be set in advance according to a distance P1 between adjacent two of the outlets 3a.

The distances P1 between the outlets 3a may be identical, or at least one of the distances P1 may be different from another distance P1. For example, the distances P1 between the outlets 3a may be narrower as the outlets 3a are closer to the outer periphery of the substrate W. In other words, the distances P1 between the outlets 3a may decrease with a monotonical non-increase toward the outer periphery of the substrate W. With this structure, the processing part 1 can supply the outer periphery portion of the substrate W with a processing liquid at a higher flow rate. Thus, the processing part 1 can more uniformly supply the main surface Wa of the substrate W with the processing liquid.

The movement range R1 may be a range larger than or equal to the largest one of the distances P1 between adjacent two of the outlets 3a. For example, when the distances P1 of the outlets 3a are identical, the movement range R1 can be set in advance to a range larger than or equal to the distance P1. Furthermore, when the distances P1 between the outlets 3a decrease with a monotonical non-increase as the outlets 3a are located more outward of the substrate W in the radial direction, the movement range R1 can be set in advance to a range larger than or equal to the distance P1 located the most outward of the substrate W in the radial direction. For example, the storage 923 may store range information indicating the movement range R1. The controller 90 may control the first movement driver 35 based on the range information in the storage 923.

As illustrated in FIG. 8, trajectory regions T1 of the liquid landing positions are continuous in the longitudinal direction D1 of the elongated nozzle 30. In other words, all of the trajectory regions T1 have a long shape extending in the longitudinal direction D1 of the elongated nozzle 30, and include all trajectories of the liquid landing positions. In the example of FIG. 8, the trajectory regions T1 are continuous from a center portion of the substrate W (a portion including the rotation axis line Q1) to the outer edge of the substrate W. Thus, the processing liquid can land on most (e.g., almost the entire surface) of the main surface Wa of the substrate W. Consequently, the processing part 1 can more uniformly process the main surface Wa of the substrate W.

The upper limit range of the movement range R1 of the elongated nozzle 30 is not particularly limited, but may be, for example, a range double the largest one of the distances P1 or less.

### [Position of elongated nozzle in movement direction]

Next, a position of the elongated nozzle 30 in the movement direction D2 (the circumferential direction of the rotation axis line Q2 herein) in Step S2 will be described. In the example of FIG. 8, the elongated nozzle 30 moves along the longitudinal direction D1 with the longitudinal direction D1 being along the radial direction of the substrate W. In other words, the elongated nozzle 30 moves along the longitudinal direction D1 with the elongated nozzle 30 overlapping the center (i.e., the rotation axis line Q1) of the substrate W in a plan view. Putting it differently, the elongated nozzle 30 moves along the longitudinal direction D1 with the longitudinal direction D1 being along the virtual line L1 connecting the rotation axis line Q1 to the rotation axis line Q2.

In the example of FIG. 8, the die D0 is located at the center of the substrate W. Here, when the elongated nozzle 30 is located at the aforementioned position, a cumulative time for which the processing liquid from the elongated nozzle 30 lands on the die D0 at the center of the substrate W is prolonged. In other words, the cumulative time for which the processing liquid lands on the die D0 at the center of the substrate W is longer than that of each of the other dies D0. Thus, there is a danger that a degree of the processing on the die D0 at the center of the substrate W is greater than that on each of the other dies D0.

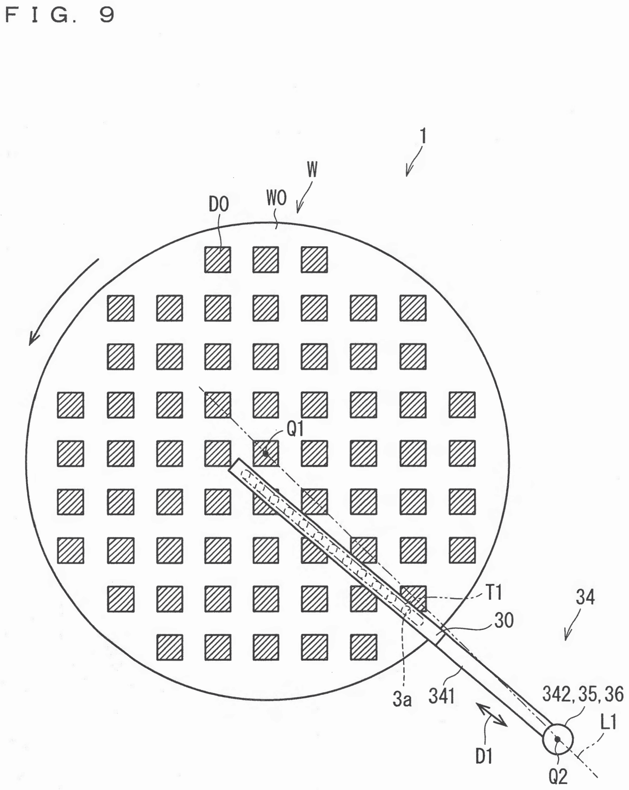

FIG. 9 is a plan view schematically illustrating another example state of the processing part 1 in Step S2. As illustrated in FIG. 9, the elongated nozzle 30 may move along the longitudinal direction D1 in Step S2 with the longitudinal direction D1 being off the virtual line L1. In other words, the processing part 1 may move the elongated nozzle 30 along the longitudinal direction D1 with the elongated nozzle 30 being off the center of the substrate W in the movement direction D2 (the circumferential direction of the rotation axis line Q2 herein). An angle between the longitudinal direction D1 and the virtual line L1 of the elongated nozzle 30 may be, for example, 0.5 degree or more and 30 degrees or less. In the example of FIG. 9, the die D0 is disposed at the center of the substrate W (i.e., a portion overlapping the rotation axis line Q1). The elongated nozzle 30 may be off the virtual line L1 to the extent that the elongated nozzle 30 does not overlap the die D0 disposed at the center of the substrate W in a plan view. Alternatively, the elongated nozzle 30 may be off the virtual line L1 to the extent that the elongated nozzle 30 overlaps only a corner of the die D0 disposed at the center of the substrate W in a plan view.

Here, the elongated nozzle 30 does not overlap the center (i.e., the rotation axis line Q1) of the substrate W in a plan view. Thus, it is possible to continuously avoid landing of the processing liquid on the center of the substrate W. In other words, it is possible to continuously avoid landing of the processing liquid on the die D0 at the center of the substrate W. Thus, it is possible to reduce a difference between the degree of the processing on the die D0 at the center of the substrate W and the degree of the processing on another die D0. In other words, the processing part 1 can process the dies D0 of the substrate W with higher uniformity.

### [Position of elongated nozzle according to arrangement mode of dies]

Next, arrangement modes of the dies D0 on the substrate W will be described. There are various types of the arrangement modes of the dies D0. Specifically, the arrangement modes of the dies D0 include a first arrangement mode and a second arrangement mode to be described next. The first arrangement mode is a mode in which one of the dies D0 is disposed at the center of the substrate W in a plan view. In the examples of FIGS. 8 and 9, the dies D0 are disposed on the support substrate WO in the first arrangement mode. Since the number of the dies D0 in each of a column and a row which pass through the center of the substrate W is an odd number in FIGS. 8 and 9, one die D0 is located at the center of the substrate W.

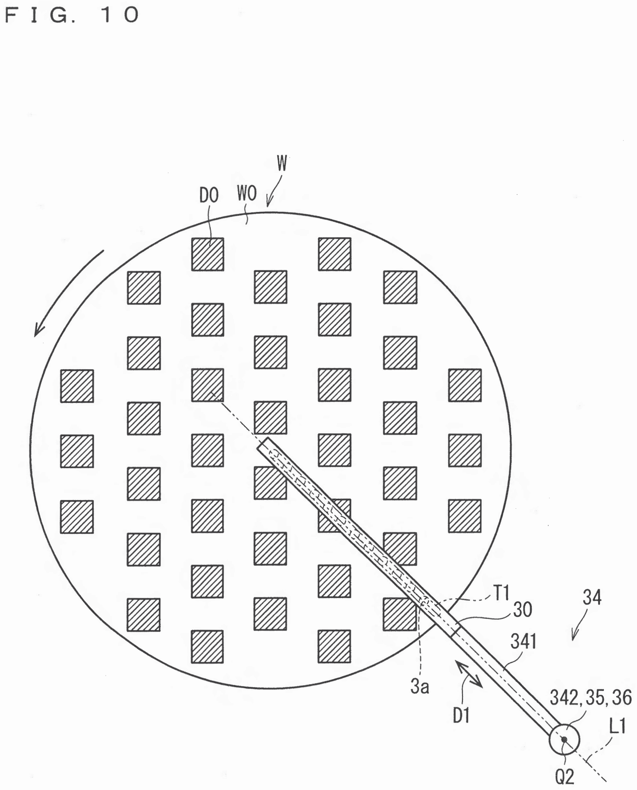

The second arrangement mode is a mode in which none of the dies D0 is disposed at the center of the substrate W in a plan view. FIG. 10 is a plan view schematically illustrating an example structure of the substrate W with the support substrate WO on which dies D0 are disposed in the second arrangement mode. Since the number of the dies D0 in each of a column and a row which pass through the center of the substrate W is an even number in the example of FIG. 10, the die D0 is not located at the center of the substrate W. In other words, the support substrate WO is exposed at the center of the substrate W. In the example of FIG. 10, the dies D0 are arranged in a staggered manner.

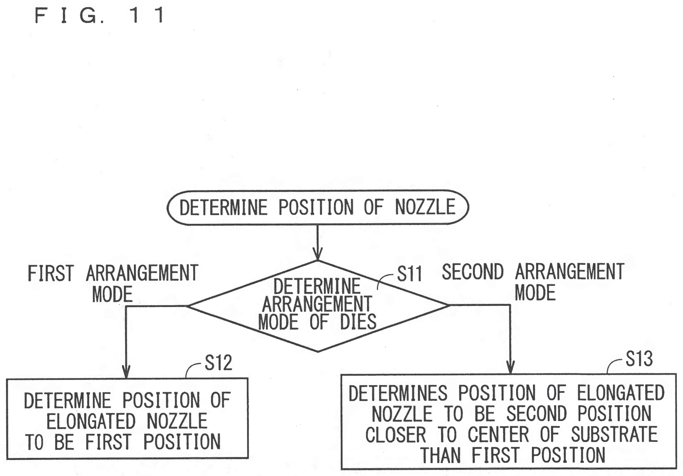

The processing part 1 may make the position of the elongated nozzle 30 in the movement direction D2 in Step S2 differ according to an arrangement mode of the dies D0. FIG. 11 is a flowchart illustrating an example method of determining the position of the elongated nozzle 30 in the movement direction D2. This flowchart is executed before Step S2 is executed.

Step S2 includes Step S3 (the chemical solution supply step) and S4 (the rinse liquid supply step). The controller 90 may determine the position of the elongated nozzle 30 in Step S3 or Step S4, according to the arrangement mode of the dies D0. Conversely speaking, the position of the elongated nozzle 30 in the movement direction D2 in one of Step S3 and Step S4 may be constant, irrespective of the arrangement mode of the dies D0. The following will be described based on the position of the elongated nozzle 30 in Step S2 as a representative.

First, the controller 90 determines whether the arrangement mode of the dies D0 of the substrate W to be loaded into the processing part 1 is the first arrangement mode or the second arrangement mode (Step S11: a determining step). For example, an external device may transmit information indicating the arrangement mode of the dies D0 (hereinafter referred to as substrate information) to the controller 90. Alternatively, the user may input the substrate information into the controller 90 using a user interface (not illustrated). The controller 90 determines whether the arrangement mode of the dies D0 is the first arrangement mode or the second arrangement mode, based on the substrate information.

When the arrangement mode of the dies D0 is the first arrangement mode, the controller 90 determines the position of the elongated nozzle 30 in Step S2 to be a first position to be described next (Step S12). In other words, the first position is a position in which the elongated nozzle 30 is off the center of the substrate W in a plan view. In other words, the first position is a position in which the longitudinal direction D1 of the elongated nozzle 30 is off the virtual line L1 (see FIG. 9). The first position is, for example, set in advance, and may be stored in, for example, the storage 923. As a specific example, the first position may be a position in which the elongated nozzle 30 does not overlap the die D0 at the center of the substrate W in a plan view or a position in which the elongated nozzle 30 overlaps only a corner of the die D0 at the center of the substrate W in a plan view.

When the arrangement mode of the dies D0 is the second arrangement mode, the controller 90 determines the position of the elongated nozzle 30 in Step S2 to be a second position to be described next (Step S13). In other words, the second position is a position closer to the center of the substrate W than the first position in a plan view (see also FIG. 10). Putting it differently, the second position is a position in which the angle between the longitudinal direction D1 and the virtual line L1 is smaller than an angle between the longitudinal direction D1 and the virtual line L1 at the first position. The second position is, for example, set in advance, and may be stored in, for example, the storage 923. As a specific example, the second position may be a position in which the longitudinal direction D1 of the elongated nozzle 30 is along the virtual line L1.

As described above, the controller 90 employs the first position as the position of the elongated nozzle 30 in the movement direction D2 in Step S2 for the substrate W including the dies D0 arranged in the first arrangement mode. In other words, the processing part 1 dispenses the processing liquid from the outlets 3a while moving the elongated nozzle 30 along the longitudinal direction D1 in a first state in which the elongated nozzle 30 is off the center of the substrate W in Step S2 (see also FIG. 9). Specifically, the controller 90 first controls the second movement driver 36 such that the elongated nozzle 30 is moved to the first position. Then, the controller 90 causes the elongated nozzle 30 to dispense a processing liquid from the outlets 3a by opening the valve 32 while controlling the first movement driver 35 such that the elongated nozzle 30 is moved along the longitudinal direction D1. Consequently, the processing part 1 can perform processes on the dies D0 more uniformly.

The controller 90 employs the second position as the position of the elongated nozzle 30 in Step S2 for the substrate W including the dies D0 arranged in the second arrangement mode. In other words, the processing part 1 dispenses a processing liquid from the outlets 3a while moving the elongated nozzle 30 along the longitudinal direction D1 in a second state in which the elongated nozzle 30 is closer to the center of the substrate W than that in the first state in the movement direction D2 (see also FIG. 10). Specifically, the controller 90 first controls the second movement driver 36 such that the elongated nozzle 30 is moved to the second position. Then, the controller 90 causes the elongated nozzle 30 to dispense a processing liquid from the outlets 3a by opening the valve 32 while controlling the first movement driver 35 such that the elongated nozzle 30 is moved along the longitudinal direction D1.

Although the cumulative time for which the processing liquid lands on the center of the substrate W is prolonged, the die D0 is not disposed at the center of the substrate W. Thus, excessive processes on the die D0 can be avoided. Furthermore, since the elongated nozzle 30 is along the radial direction of the substrate W, the processing liquid can more isotropically land on the respective dies D0 on the main surface Wa of the substrate W. Consequently, the processing part 1 can perform processes on the dies D0 more uniformly.

When a chemical solution such as an etching solution is used as a processing liquid, a difference between a degree of the processing at the liquid landing position and a degree of the processing at a position except the liquid landing position tends to increase, which tends to induce a non-uniform process on the main surface Wa of the substrate W. In view of this, the processing part 1 may make the position of the elongated nozzle 30 in the movement direction D2 differ according to an arrangement mode of the dies D0 in Step S3 (the chemical solution supply step). Consequently, the processing part 1 can more effectively suppress the non-uniform process on the main surface Wa of the substrate W.

### [Camera]

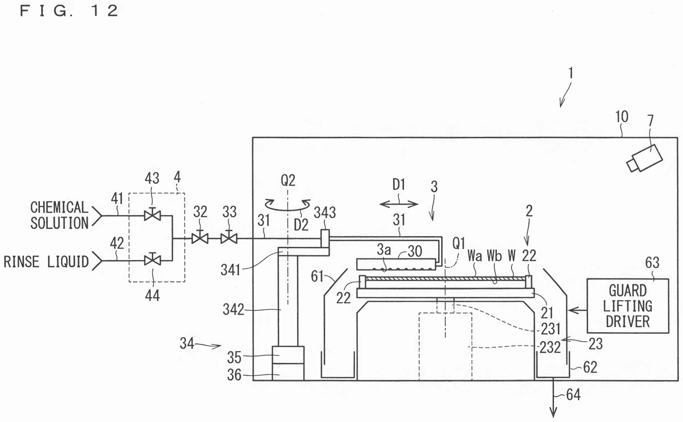

The substrate processing apparatus 100 may include a camera 7, and the camera 7 may be disposed in the processing part 1. FIG. 12 is a diagram schematically illustrating an example structure of the processing part 1 including the camera 7. The camera 7 is controlled by the controller 90, and images an imaging range to generate image data. The camera 7 includes, for example, a solid-state image sensing device such as a charge coupled device (CCD) or a complementary metal oxide semiconductor (CMOS), and an optical system such as a lens.

The camera 7 may be disposed in the chamber 10. Alternatively, the camera 7 may be disposed outside of the chamber 10. In such a case, an imaging window (a transparent part) is disposed in the chamber 10. The camera 7 images an imaging range within the chamber 10 through the imaging window. In the example of FIG. 12, the camera 7 is set in a setting position where its imaging range contains the main surface Wa of the substrate W held by the substrate holder 2. In the example of FIG. 12, the camera 7 is disposed above the substrate holder 2 and outward of the substrate holder 2 in the radial direction. The camera 7 images an imaging range obliquely downward. In other words, the camera 7 images the main surface Wa of the substrate W held by the substrate holder 2 to generate image data. The camera 7 outputs the image data to the controller 90.

The image data includes the main surface Wa of the substrate W. The controller 90 identifies an arrangement mode of the dies D0 on the substrate W, based on the image data. The controller 90 determines a position of the elongated nozzle 30 in the movement direction D2 in Step S2, according to the identified arrangement mode of the dies D0.

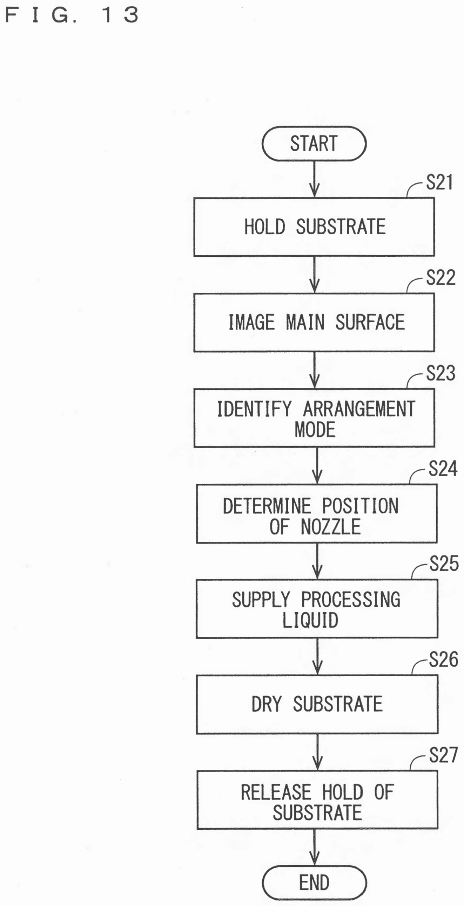

FIG. 13 is a flowchart illustrating example operations of the processing part 1 including the camera 7. The controller 90 controls the substrate processing apparatus 100 according to a predetermined procedure (a recipe), so that the flowchart in FIG. 13 is implemented.

First, the center robot 122 transports the substrate W to the processing part 1, and the substrate holder 2 holds the substrate W (Step S21: a holding step), similarly to Step S1.

Next, the camera 7 images the main surface Wa of the substrate W held by the substrate holder 2 to generate image data (Step S22: an imaging step). Specifically, the controller 90 controls the camera 7, and causes the camera 7 to image the main surface Wa of the substrate W. The camera 7 outputs the image data to the controller 90.

Next, the controller 90 identifies an arrangement mode of the dies D0 based on the image data (Step S23: an arrangement identification step). As a specific example, the controller 90 may identify the arrangement mode of the dies D0, based on the comparison between the image data and reference image data to be described next. The reference image data is, for example, image data including the main surface Wa of the substrate W on which the dies D0 are disposed in the first arrangement mode, and is generated by the camera 7 in advance. In other words, the camera 7 images the main surface Wa of the substrate W to generate the image data in advance while the substrate holder 2 holds the substrate W on which the dies D0 are disposed in the first arrangement mode. The controller 90 causes the storage 923 to store the image data as the reference image data in advance.

When the arrangement mode of the dies D0 is the first arrangement mode, the image data generated by the camera 7 in Step S22 is similar to the reference image data. When the arrangement mode of the dies D0 is the second arrangement mode, the image data generated by the camera 7 in Step S22 is not similar to the reference image data.

Then, the controller 90 calculates a degree of similarity between the image data from the camera 7 and the reference image data read from the storage 923. The degree of similarity is not particularly limited, but may be, for example, a sum of squared differences between pixel values, a sum of absolute differences between pixel values, or a known degree of similarity such as a normalized cross-correlation or a zero-mean normalized cross correlation.

The controller 90 determines whether the degree of similarity is higher than or equal to a predetermined threshold. When the degree of similarity is higher than or equal to the threshold, the controller 90 determines the arrangement mode of the dies D0 to be the first arrangement mode. When the degree of similarity is lower than the threshold, the controller 90 determines the arrangement mode of the dies D0 to be the second arrangement mode.

The reference image data is not limited to the aforementioned example but may be, for example, image data including the substrate W on which the dies D0 are disposed in the second arrangement mode. In other words, the camera 7 images the main surface Wa of the substrate W to generate the image data in advance while the substrate holder 2 holds the substrate W on which the dies D0 are disposed in the second arrangement mode. The controller 90 causes the storage 923 to store the image data as the reference image data. Here, when the degree of similarity is lower than the threshold, the controller 90 determines the arrangement mode of the dies D0 to be the first arrangement mode. When the degree of similarity is higher than or equal to the threshold, the controller 90 determines the arrangement mode of the dies D0 to be the second arrangement mode.

Next, the controller 90 determines the position of the elongated nozzle 30 in the movement direction D2 in Step S25 to be described later, according to the arrangement mode of the dies D0 (Step S24: a nozzle position determining step). This identification method is identical to Steps S11 to S13.

Next, the processing part 1 supplies processing liquids to the main surface Wa of the substrate W (Step S25: a processing liquid supply step), similarly to Step S2. The processing part 1 moves the elongated nozzle 30 at the position of the movement direction D2 determined in Step S24, along the longitudinal direction D1.

Next, the processing part 1 dries the substrate W (Step S26: a drying step), similarly to Step S5. Then, the substrate holder 2 releases a hold of the substrate W (Step S7: a hold releasing step), similarly to Step S6. Furthermore, the guard lifting driver 63 lowers the guard 61 to the lower position, and the center robot 122 unloads the processed substrate W from the processing part 1.

As described above, the controller 90 automatically identifies the arrangement mode of the dies D0 based on the image data of the camera 7. Thus, the usability of the substrate processing apparatus 100 can be improved without any necessity of inputting the arrangement mode of the dies D0 by the user.

The camera 7 is disposed in the processing part 1 in the aforementioned example, which is not always limited to this. The camera 7 should be disposed in a position at which the main surface Wa of the substrate W can be imaged in the substrate processing apparatus 100. For example, the camera 7 may be disposed above the placement part 123. Specifically, the camera 7 may be set in a setting position where its imaging range contains the main surface Wa of the substrate W placed on the placement part 123.

While the method of processing a substrate is described in detail above, the description is in all aspects illustrative and does not restrict this disclosure. The aforementioned various modifications are applicable in combination unless any contradiction occurs. Therefore, numerous modifications and variations that have not yet been exemplified are devised without departing from the scope of the present disclosure.

For example, the dispenser 3 of the processing part 1 may include another nozzle different from the elongated nozzle 30. The nozzle may be a straight nozzle that dispenses a processing liquid in the form of a continuous stream toward the main surface Wa of the substrate W held by the substrate holder 2. The processing part 1 may cause the straight nozzle to dispense a rinse liquid toward the center of the main surface Wa of the substrate W between Step S2 (Step S4) and Step S5 or between Steps S25 and S26.

The present disclosure includes the following aspects.

A first aspect is a method of processing a substrate, the method including: a holding step of holding the substrate; and a processing liquid supply step of dispensing a processing liquid from a plurality of outlets of an elongated nozzle toward a main surface of the substrate while the substrate is rotated and the elongated nozzle is moved along a longitudinal direction, the elongated nozzle extending along the longitudinal direction, the plurality of outlets being aligned along the longitudinal direction.

A second aspect is the method according to the first aspect, wherein a movement range of the elongated nozzle in the processing liquid supply step is a range larger than or equal to a largest one of distances between the plurality of outlets.

A third aspect is the method according to the first or second aspect, wherein the processing liquid supply step includes dispensing the processing liquid from the plurality of outlets while the elongated nozzle is moved along the longitudinal direction in a first state in which the elongated nozzle is off a center of the substrate in a movement direction crossing the longitudinal direction.

A fourth aspect is the method according to the third aspect, wherein the main surface of the substrate includes a plurality of dies, and when an arrangement mode of the plurality of dies on the substrate is a first arrangement mode in which one of the plurality of dies is disposed at the center of the substrate, the processing liquid supply step includes dispensing the processing liquid from the plurality of outlets while the elongated nozzle is moved along the longitudinal direction in the first state.

A fifth aspect is the method according to the fourth aspect, wherein when the arrangement mode is a second arrangement mode in which none of the plurality of dies is disposed at the center of the substrate, the processing liquid supply step includes dispensing the processing liquid from the plurality of outlets while the elongated nozzle is moved along the longitudinal direction in a second state in which the elongated nozzle is closer to the center of the substrate than the elongated nozzle in the first state in the movement direction.

A sixth aspect is the method according to the fourth or fifth aspect, the method including: an imaging step of imaging the main surface of the substrate using a camera to generate image data; and an arrangement identification step of identifying the arrangement mode based on the image data.

A seventh aspect is a substrate processing apparatus including: a substrate holder that rotates a substrate while holding the substrate; a dispenser including an elongated nozzle including a plurality of outlets, the dispenser dispensing a processing liquid from the plurality of outlets toward a main surface of the substrate, the plurality of outlets being aligned along a longitudinal direction of the elongated nozzle; and a first movement driver that moves the elongated nozzle along the longitudinal direction.

An eighth aspect is the substrate processing apparatus according to the seventh aspect which further includes a second movement driver that moves the elongated nozzle along a movement direction crossing the longitudinal direction, wherein the second movement driver moves the elongated nozzle along the movement direction between a processing position facing the substrate in a vertical direction and a waiting position outward of the substrate holder in a radial direction.

According to the first and seventh aspects, since a plurality of liquid landing positions of the processing liquid on the main surface of the substrate can be moved along the longitudinal direction, the main surface of the substrate can be more uniformly processed.

According to the second aspect, trajectory regions in movement of the liquid landing positions on the main surface of the substrate are continuous in the longitudinal direction. Thus, the processing liquid can land on most of the main surface of the substrate in the processing liquid supply step. Consequently, the main surface of the substrate can be more uniformly processed.

The third aspect can avoid the processing liquid from continuously landing on the center of the main surface of the substrate. Thus, the main surface of the substrate can be more uniformly processed.

The fourth aspect can avoid the processing liquid from continuously landing on the die disposed at the center of the substrate. Thus, the plurality of dies can be more uniformly processed.

According to the fifth aspect, the processing liquid can isotropically land on the substrate. Thus, the plurality of dies can be more uniformly processed.

According to the sixth aspect, the usability can be improved.

According to the eighth aspect, the processing position and the waiting position are aligned in the movement direction crossing the longitudinal direction. If the processing position and the waiting position are aligned in the longitudinal direction, a distance between the processing position and the waiting position is increased by the size of the elongated nozzle in the longitudinal direction. This increases the size of a substrate processing apparatus. In contrast, the size of the substrate processing apparatus according to the present disclosure can be reduced because the processing position and the waiting position are aligned in the movement direction.

## Claims

1. A method of processing a substrate (W), the method comprising:
holding the substrate (W); and
dispensing a processing liquid from a plurality of outlets (3a) of an elongated nozzle (30) toward a main surface (Wa) of the substrate (W) while the substrate (W) is rotated and the elongated nozzle (30) is moved along a longitudinal direction (D1), the elongated nozzle (30) extending along the longitudinal direction (D1), the plurality of outlets (3a) being aligned along the longitudinal direction (D1).

2. The method according to claim 1,
wherein a movement range of the elongated nozzle (30) in the dispensing is a range larger than or equal to a largest one of distances between the plurality of outlets (3a).

3. The method according to claim 1 or 2,
wherein the dispensing includes dispensing the processing liquid from the plurality of outlets (3a) while the elongated nozzle (30) is moved along the longitudinal direction (D1) in a first state in which the elongated nozzle (30) is off a center of the substrate (W) in a movement direction (D2) crossing the longitudinal direction (D1).

4. The method according to claim 3,
wherein the main surface (Wa) of the substrate (W) includes a plurality of dies (D0), and
when an arrangement mode of the plurality of dies (D0) on the substrate (W) is a first arrangement mode in which one of the plurality of dies (D0) is disposed at the center of the substrate (W), the dispensing includes dispensing the processing liquid from the plurality of outlets (3a) while the elongated nozzle (30) is moved along the longitudinal direction (D1) in the first state.

5. The method according to claim 4,
wherein when the arrangement mode is a second arrangement mode in which none of the plurality of dies (D0) is disposed at the center of the substrate (W), the dispensing includes dispensing the processing liquid from the plurality of outlets (3a) while the elongated nozzle (30) is moved along the longitudinal direction (D1) in a second state in which the elongated nozzle (30) is closer to the center of the substrate (W) than the elongated nozzle (30) in the first state in the movement direction (D2).

6. The method according to claim 4 or 5, comprising:
imaging the main surface (Wa) of the substrate (W) using a camera (7) to generate image data; and
identifying the arrangement mode based on the image data.

7. A substrate processing apparatus, comprising:
a substrate holder (2) that rotates a substrate (W) while holding the substrate (W);
a dispenser (3) including an elongated nozzle (30) including a plurality of outlets (3a), the dispenser (3) dispensing a processing liquid from the plurality of outlets (3a) toward a main surface (Wa) of the substrate (W), the plurality of outlets (3a) being aligned along a longitudinal direction (D1) of the elongated nozzle (30); and
a first movement driver (35) that moves the elongated nozzle (30) along the longitudinal direction (D1).

8. The substrate processing apparatus according to claim 7, further comprising
a second movement driver (36) that moves the elongated nozzle (30) along a movement direction (D2) crossing the longitudinal direction (D1),
wherein the second movement driver (36) moves the elongated nozzle (30) along the movement direction (D2) between a processing position facing the substrate (W) in a vertical direction and a waiting position outward of the substrate holder (2) in a radial direction.
